(19) **Europäisches Patentamt**
**European Patent Office**
**Office européen des brevets**

(11) **EP 4 184 537 A1**

(12) **EUROPEAN PATENT APPLICATION**

(43) Date of publication:
**24.05.2023 Bulletin 2023/21**

(21) Application number: **21306605.3**

(22) Date of filing: **18.11.2021**

(51) International Patent Classification (IPC):
**H01G 4/012** (2006.01)    **H01G 4/30** (2006.01)
**H01G 4/33** (2006.01)    **H01G 4/38** (2006.01)
**H01L 49/02** (2006.01)

(52) Cooperative Patent Classification (CPC):
**H01G 4/33; H01G 4/012; H01G 4/306; H01G 4/385;**
**H01L 28/86; H01L 28/90;** H01G 4/30

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Murata Manufacturing Co., Ltd.**
**Nagaokakyo-shi, Kyoto 617-8555 (JP)**

(72) Inventors:
• **NORMAND, Nicolas**
  **14200 HEROUVILLE SAINT CLAIR (FR)**
• **BOUVIER, Stéphane**
  **14610 CAIRON (FR)**
• **THIEBOT, Alain**
  **14280 SAINT GERMAIN LA BLANCHE HERBE**
  **(FR)**

(74) Representative: **Cabinet Beau de Loménie**
  **158, rue de l'Université**
  **75340 Paris Cedex 07 (FR)**

(54) **AN ELECTRICAL DEVICE COMPRISING STACKED CAPACITIVE STRUCTURES WITH ELECTRODES CONNECTED FROM BOTTOM TO TOP AND TOP TO BOTTOM**

(57)    An electrical device comprising:
a first stacked capacitive structure comprises N electrodes (E1_1, ..., E1_N), from the first to the N-th electrode, each having a 3D shape, and conformally stacked, the electrodes being all separated by N-1 dielectric layers so that N-1 stacked capacitors are formed in the first stacked capacitive structure,
a second stacked capacitive structure comprises N electrodes (E2_1, ..., E2_N), from the first to the N-th electrode, each having a 3D shape, and conformally stacked, the electrodes being all separated by N-1 dielectric layers so that N-1 stacked capacitors are formed in the second stacked capacitive structure,
further comprising N electrical connections (CN1_N, ..., CNN_1), wherein the X-th electrode of the first stacked capacitive structure is connected by an electrical connection to the N-X+1-th electrode of the second stacked capacitive structure.

FIG. 3

EP 4 184 537 A1

**Description**

Field of the Invention

The present invention relates to the field of electrical devices, and more precisely to capacitive devices used in high voltage applications.

Technical Background

Electronic components such as capacitors may be integrated into semiconductor products in a variety of forms. For example, planar capacitors may be formed above semiconductor substrates by forming two planar electrodes separated by a dielectric layer. However planar capacitors provide low capacitance density, this implies that a high value capacitance will consume a significant area of silicon.

To overcome this issue, it has been proposed to form three-dimensional structures to increase the capacitance of capacitors. Capacitance densities of the order of a Farad per $m^2$ have been achieved using three-dimensional (3D) capacitors.

A 3D capacitor comprises functional electrodes presenting a relief (for example they comprise a surface presenting a relief or they are formed on a relief such as a pore, a hole, a trench, or a pillar). Typically, it is possible to form a conductive 3D structure by using Deep Reactive Ion Etching, followed by subsequent deposition steps of a dielectric and of a conductive material to form a capacitor. Document WO 2007125510 discloses a method for forming such a 3D capacitor.

While these solutions are suitable to increase the capacitance of integrated capacitors, there is also a need for devices which can operate under high voltages.

A typical integrated (3D) capacitor can be rated to be used under a maximum voltage of about 3,6V. For applications where tens of volts should be used, it is known to use capacitors connected in series (typically with a higher capacitance value). This solution, using a plurality of distinct capacitors, has several drawbacks. The total capacitance value is unstable (the capacitance value may vary between devices), the ESR (Equivalent Series Resistor) is high (for example 30 Ohms), their lifetime is limited (which can be a result of an imbalance between components).

Also, when these capacitors are formed above a semiconductor substrate, with a bottom electrode comprising doped silicon, a diode is usually formed between the bottom electrode and the undoped substrate: by connecting capacitors in series, diodes are formed between every capacitor electrode and the substrate except for the one of the last capacitor (the one having an electrode not connected to another capacitor through its bottom electrode). Floating diodes are an issue, and having one capacitor exempt of a floating diode on one electrode is a further issue in terms of imbalance.

Further, using current technologies, using 3D capacitors and MIMIM (Metal-Insulator-Metal-Insulator-Metal) structures is an unsatisfactory solution to connect capacitors in series. In these structures, it is known that the surface area of the top capacitors will be less than the surface area of the bottom capacitors, because materials are deposited conformally on 3D structure, which leaves less and less area to form capacitors above previously formed capacitors. Hence, an imbalance between the capacitances would be observed if a MIMIM capacitor (two or more capacitors in series) was to be used to achieve high voltages.

The present invention has been made in the light of the above problems.

Summary of the Invention

The present invention provides an electrical device comprising at least a first stacked capacitive structure and a second stacked capacitive structure, the first and the second stacked capacitive structure being adjacent and formed above a same substrate,

wherein the first stacked capacitive structure comprises N (N superior or equal to 3) electrodes, from the first to the N-th electrode (the electrodes are designated as first electrode, second electrode, ... N-th electrode), each having a 3D shape, and conformally stacked (each electrode conforms to the shape of the layer on which it is deposited) from the first electrode of the N electrodes at the bottom of the structure to the N-th electrode at the top of the structure, the electrodes being all separated by N-1 dielectric layers so that N-1 stacked capacitors (the capacitors are designated as first capacitor (at the bottom), second capacitor, ... N-1-th capacitor) are formed in the first stacked capacitive structure,

wherein the second stacked capacitive structure comprises N electrodes, from the first to the N-th electrode (the electrodes are also designated as first electrode, second electrode, ... N-th electrode), each having a 3D shape, and conformally stacked from the first electrode of the N electrodes at the bottom of the structure to the N-th electrode at the top of the structure, the electrodes being all separated by N-1 dielectric layers so that N-1 stacked capacitors (the capacitors are also designated as first capacitor (at the bottom), second capacitor, ... N-1-th capacitor) are formed in the second stacked capacitive structure,

further comprising N electrical connections for connecting each electrode of the first stacked capacitive structure to a respective electrode of the second stacked capacitive structure, wherein the X-th electrode of the first stacked capacitive structure is connected by an electrical connection of the N electrical connections to the N-X+1-th electrode of the second stacked capacitive structure.

Thus, this device uses 3D capacitors formed above same a substrate (i.e. they are integrated capacitors integrated into a same integrated component) by stacking electrode material and dielectric layers alternatively. Here, two stacks are formed.

The top electrodes of both stacked capacitive structures can be the two terminals of the device (i.e. the input and the output).

In order to equilibrate the surface area of the bottom capacitors (here the surface used to calculate their capacitance) with the surface area of the top capacitors (generally smaller than the surface of the bottom capacitors), it is proposed to electrically connect every electrode of the first stack with an electrode from the second stack, by going from top to bottom in the first stack, and bottom to top in the second stack.

A well balanced structure is obtained, capable of withstanding high voltages, because it is equivalent to a connection in series of capacitors.

Here, the electrodes all have 3D shapes, and they are all formed conformally. The dielectric layers are also formed conformally. Consequently, a plurality of 3D capacitors is formed.

It should be noted that a 3D capacitor comprises functional electrodes presenting a relief (for example the capacitor comprises a surface presenting a relief or they are formed on a relief such as a pore, a hole, a trench, or a pillar) which is the 3D shape. 3D capacitors may also be defined as comprising functional electrodes having surfaces extending in three directions orthogonal with each other (for example two directions parallel to the support and one direction orthogonal with the support). In the invention a functional electrode is an electrode which faces the other electrode of the capacitor and participates to the capacitance of the device.

The substrate can be a semi-conductor substrate, for example comprising silicon. Also, the device can be an integrated device.

According to a particular embodiment, the X-th capacitor of the N-1 stacked capacitors of the first stacked capacitive structure has the same capacitance value as the X-the capacitor of the N-1 stacked capacitors of the second stacked capacitive structure.

In this structure, it appears that a better balance is obtained.

According to a particular embodiment, the first stacked capacitive structure has an annular shape and surrounds the second stacked capacitive structure (for example having a circular shape), or
the first stacked capacitive structure has a rectangular shape and the second stacked capacitive structure has the same rectangular shape.

These structures have been observed to be particularly advantageous. These shapes are observed from the top of the device.

According to a particular embodiment, the first electrode of the first stacked capacitive structure comprises a semiconductor region having a 3D shape and the first electrode of the second stacked capacitive structure comprises a semiconductor region having a 3D shape.

According to a particular embodiment, the semiconductor regions having a 3D shape of the first electrodes comprise a plurality of holes, or a plurality of trenches, or a plurality of pillars.

According to a particular embodiment, the semiconductor region of the first electrode of the first stacked capacitive structure is formed by doping a portion of a semiconductor substrate (it comprises doped semiconductor material), and the device comprises a first diode formed between the semiconductor region of the first electrode of the first stacked capacitive structure and the undoped semiconductor substrate (i.e. the portion not doped when forming the semiconductor region by doping), and

the semiconductor region of the first electrode of the second stacked capacitive structure is formed by doping a portion of the same semiconductor substrate, and the device comprises a second diode formed between the semiconductor region of the first electrode of the second stacked capacitive structure and the undoped semiconductor substrate (i.e. the portion not doped when forming the semiconductor region by doping),
wherein the anodes of the first diode and of the second diode are connected together through the undoped semiconductor substrate.

This particular embodiment has been observed to provide a structure in which two diodes are connected in parallel to the equivalent capacitor formed by the two stacked structures. Through the electrical connections, this equivalent capacitor is formed between the two electrodes of rank N, and the two diodes arranged in series but in opposite directions are connected in parallel to this equivalent capacitor. The two diodes form a voltage limiting device that forms a protection of the capacitor.

According to a particular embodiment, the device further comprises a supplementary stacked capacitive structure comprising N electrodes, from the first to the N-th electrode, each having a 3D shape, and conformally stacked from the first electrode of the N electrodes at the bottom of the structure to the N-th electrode at the top of the structure, the electrodes being all separated by N-1 dielectric layers so that N-1 stacked capacitors are formed in the second stacked capacitive structure, and wherein the N electrical connections also connect the X-th electrode of the supplementary stacked capacitive structure to the N-X+1-th electrode of either the first or the second stacked capacitive structure.

It is possible to form a device with more than 2 stacked capacitive structures, the supplementary stacked capacitive structure (one or more) can be connected either to balance the first or the second stacked capacitive structure. This allows balancing even more the differences between the bottom and top capacitors.

According to a particular embodiment, N is equal to 4.

A structure comprising two stacks of 3 capacitors has been observed to provide a good balance while limiting the ESR of the structure.

The invention also provides a method of manufacturing an electrical device comprising at least a first stacked capacitive structure and a second stacked capacitive structure, the first and the second stacked capacitive structure being adjacent and formed above a same substrate,

wherein forming the first stacked capacitive structure comprises forming successively N electrodes, from the first to the N-th electrode, each having a 3D shape, and conformally stacked from the first electrode of the N electrodes at the bottom of the structure to the N-th electrode at the top of the structure, and forming N-1 dielectric layers separating all the electrodes so that N-1 stacked capacitors are formed in the first stacked capacitive structure,

wherein forming the second stacked capacitive structure comprises forming successively N electrodes, from the first to the N-th electrode, each having a 3D shape, and conformally stacked from the first electrode of the N electrodes at the bottom of the structure to the N-th electrode at the top of the structure, and forming N-1 dielectric layers separating all the electrodes so that N-1 stacked capacitors are formed in the second stacked capacitive structure,

further comprising forming N electrical connections for connecting each electrode of the first stacked capacitive structure to a respective electrode of the second stacked capacitive structure, wherein the X-th electrode of the first stacked capacitive structure is connected by an electrical connection of the N electrical connections to the N-X+1-th electrode of the second stacked capacitive structure.

This method can be adapted to manufacture any electrical device as described before.

According to a particular embodiment, the X-th capacitor of the N-1 stacked capacitors of the first stacked capacitive structure has the same capacitance value as the X-the capacitor of the N-1 stacked capacitors of the second stacked capacitive structure.

According to a particular embodiment, the first stacked capacitive structure has an annular shape and surrounds the second stacked capacitive structure, or the first stacked capacitive structure has a rectangular shape and the second stacked capacitive structure has the same rectangular shape.

According to a particular embodiment, the first electrode of the first stacked capacitive structure comprises a semiconductor region having a 3D shape and the first electrode of the second stacked capacitive structure comprises a semiconductor region having a 3D shape.

According to a particular embodiment, the semiconductor regions having a 3D shape of the first electrodes comprise a plurality of holes, or a plurality of trenches, or a plurality of pillars.

According to a particular embodiment, the semiconductor region of the first electrode of the first stacked capacitive structure is formed by doping a portion of a semiconductor substrate, so that a first diode is formed between the semiconductor region of the first electrode of the first stacked capacitive structure and the undoped semiconductor substrate, and

the semiconductor region of the first electrode of the second stacked capacitive structure is formed by doping a portion of the same semiconductor substrate, so that a second diode is formed between the semiconductor region of the first electrode of the second stacked capacitive structure and the undoped semiconductor substrate,

wherein the anodes of the first diode and of the second diode are connected together through the undoped semiconductor substrate.

According to a particular embodiment, the method further comprises forming a supplementary stacked capacitive structure comprising N electrodes, from the first to the N-th electrode, each having a 3D shape, and conformally stacked from the first electrode of the N electrodes at the bottom of the structure to the N-th electrode at the top of the structure, the electrodes being all separated by N-1 dielectric layers so that N-1 stacked capacitors are formed in the second stacked capacitive structure, and wherein the N electrical connections also connect the X-th electrode of the supplementary stacked capacitive structure to the N-X+1-th electrode of either the first or the second stacked capacitive structure.

According to a particular embodiment, N is equal to 4.

Brief Description of the Drawings

Further features and advantages of the present invention will become apparent from the following description of certain embodiments thereof, given by way of illustration only, not limitation, with reference to the accompanying drawings in which:

- Figure 1A is an example of device comprising a stacked capacitive structure in a hole,
- Figure 1B shows the device of figure 1 in an unfolded manner,
- Figure 2 shows an example of device with two stacked capacitive structures,
- Figure 3 is the equivalent circuit of the device of figure 2,

- Figure 4 is a cross section of the device of figures 2 and 3,
- Figure 5 is an example of device with N electrodes,
- Figures 6A and 6B show a device with rectangular structures,
- Figure 7 shows a device where a structure surrounds the other, and
- Figure 8 is the equivalent circuit of another exemplary device.

Detailed Description of Example Embodiments

We will now describe an electrical device comprising capacitors which is well suitable to act as a single capacitor in high voltage applications. This structure is particularly reliable as the overall capacitance can be precisely controlled, and the structure avoids imbalances between the capacitors that form the overall capacitor.

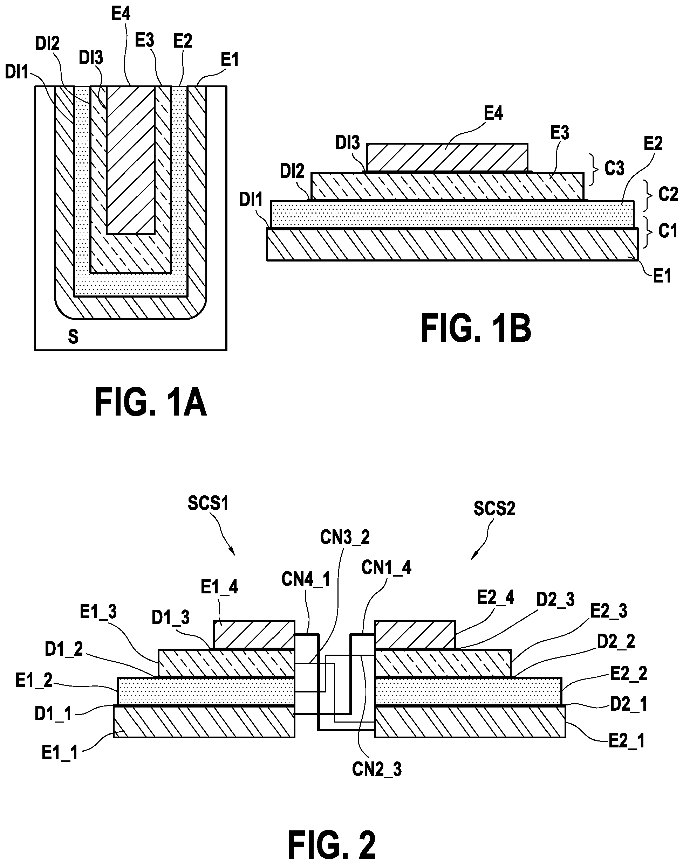

Figure 1A and 1B show a stacked capacitive structure comprising three capacitors connected in series. Figure 1A shows a cross section of this structure formed in a cavity of a semiconductor substrate, and Figure 1B shows the corresponding unfolded structure showing the difference in terms of capacitance between the different capacitors forming the stack.

More precisely, on figure 1A, a first electrode E1 has been formed by doping (n+) the walls and the bottom of a cavity formed in a substrate S (for example a semiconductor substrate having a doping level p-). Above the first electrode, a first dielectric layer DI1 (for example an ONO layer: Oxyde-Nitride-Oxyde) has been formed or deposited in a conformal manner (by conformal/conformally, what is meant is that the shape of the deposited layer matches the one of the layer below; for example, ALD (Atomic Layer Deposition) can be used to form conformal layers), and a second electrode E2 has been deposited/formed, by depositing a conductive material such as doped polysilicon. This forms capacitor C1.

Subsequent capacitors are formed by depositing a second dielectric layer DI2, a third electrode E3 (a second capacitor C2 is formed), a third dielectric layer DI3, and an electrode E4 (a third capacitor C3 is formed).

When the cavity is filled, it appears that the earlier deposited layers have a greater surface area than the later deposited layers. This is due to the narrowing of the cavity resulting from the previous deposition steps that fill the cavity.

By showing the electrodes in an unfolded manner, as has been done on figure 1B, it can be observed that there is a surface difference, and consequently a capacitance difference, between C1, C2, and C3. This makes using the three capacitors C1, C2, and C3 connected in series an imperfect solution for high voltage applications or applications where the capacitance values should be accurate. In fact, it can be difficult to predict the difference in terms of capacitance that the 3D topology induces.

This behavior can be observed over a single cavity, but also on more complex 3D structures, for example on the 3D structures described in document WO 2007125510 (plurality of pillars, plurality of holes/cavities, plurality of trenches, etc.).

From figures 1A and 1B, it appears that this solution should be improved for high voltage applications.

Figure 2 shows a device in an "unfolded" manner, analogously to figure 1B, previously described. On this figure, a device is shown comprising a first stacked capacitive structure SCS1 and a second stacked capacitive structure SCS2.

The first stacked capacitive structure comprises 4 electrodes and may be formed in a manner which is analogous to forming the 4 electrodes of the structure shown on figures 1A and 1B. With respect to the structure shown on figures 1A and 1B, the surface area of each electrode should be halved.

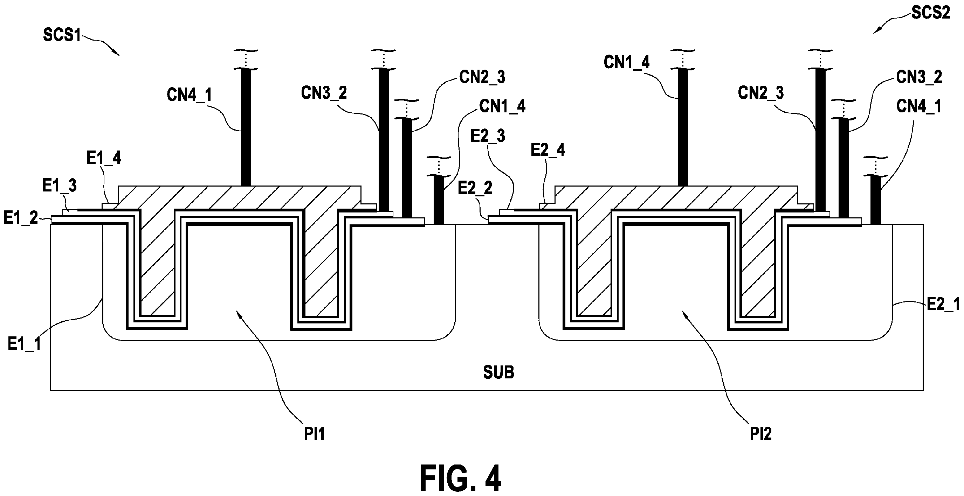

Also, and as will be described in reference to figure 4, all the electrodes of the two stacked capacitive structure are 3D electrodes.

Here, the first stacked capacitive structure comprises, from bottom to top:

- A first electrode E1_1 (for example comprising doped silicon);
- A dielectric layer D1_1 (for example an ONO layer);
- A second electrode E1_2 (for example comprising doped polysilicon);
- A dielectric layer D1_2;
- A third electrode E1_3;
- A dielectric layer D1_3; and
- A fourth electrode E1_4.

Because the structure is a 3D structure with conformal electrodes, the surface area of the electrode may decrease from the bottom to the top electrode. Three capacitors are formed, with three different capacitance values, decreasing from the bottom to the top.

The first stacked capacitive structure is balanced with the second stacked capacitive structure SCS2, formed on the same silicon substrate, and configured to comprise the same number of capacitors each with the same capacitance. The second structure is also a 3D structure with conformal electrodes.

More precisely, the second stacked capacitive structure comprises:

- A first electrode E2_1;
- A dielectric layer D2_1;
- A second electrode E2_2;
- A dielectric layer D2_2;
- A third electrode E2_3;
- A dielectric layer D2_3; and
- A fourth electrode E2_4.

The present device proposes balancing the two stacked capacitive structures by balancing a capacitor having a large capacitance with a capacitor having a smaller capacitance, by interconnecting electrodes. Electrodes from the first stack are connected to electrodes from the second stack so that all the pairs of connected electrodes have the same surface area (unfolded, as shown).

Here, four electrical connections are used:

- Electrical connection CN1_4, connecting the first electrode E1_1 of the first stacked capacitive structure to the fourth electrode E2_4 of the second stacked capacitive structure;
- Electrical connection CN2_3, connecting the second electrode E1_2 of the first stacked capacitive structure to the third electrode E2_3 of the second stacked capacitive structure;
- Electrical connection CN3_2, connecting the third electrode E1_3 of the first stacked capacitive structure to the second electrode E2_2 of the second stacked capacitive structure;
- Electrical connection CN4_1, connecting the fourth electrode E1_4 of the first stacked capacitive structure to the first electrode E2_1 of the second stacked capacitive structure.

The two top electrodes E1_4 and E2_4 can be used respectively as input and output of the device. Between these electrodes, an equivalent circuit of three capacitors in series is obtained (consequently suitable for high voltage applications), the three capacitors having substantially the same capacitance value, as well as substantially the same capacitance value as the capacitor formed in series in the structure of figures 1A and 1B.

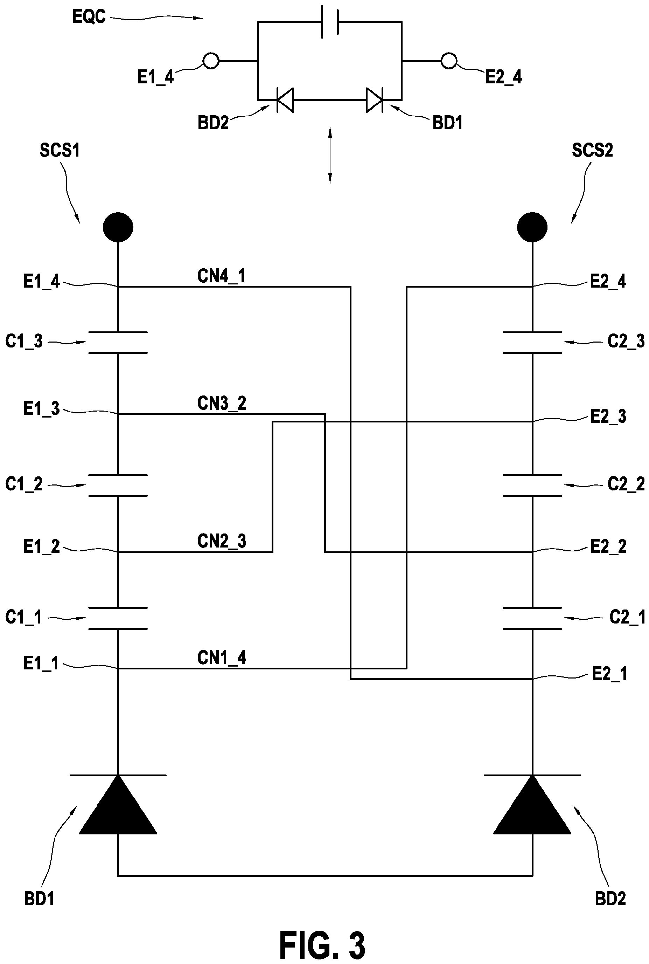

Figure 3 is a representation of the equivalent circuit of the device of figure 2. On this figure, it can be observed that using the substrate to form electrodes E1_1 and E2_1 leads respectively to forming bulk diodes BD1 and BD2. The two bulk diodes are respectively formed between a semiconductor region forming an electrode (E1_1 or E2_1, formed by doping a substrate) and the undoped substrate. These two diodes have their anodes connected together.

Preferably, and as will be shown on figure 4, the doped regions forming electrodes E1_1 and E2_1 are distinct. Also, the bulk diodes BD1 and BD2 can be shorted to ensure a proper balance between the two stacks.

This figure shows that six capacitors have been formed:

- Capacitor C1_1 formed between electrodes E1_1 and E1_2,
- Capacitor C1_2 formed between electrodes E1_2 and E1_3,
- Capacitor C1_3 formed between electrodes E1_3 and E1_4,
- Capacitor C2_1 formed between electrodes E2_1 and E2_2,
- Capacitor C2_2 formed between electrodes E2_2 and E2_3, and
- Capacitor C2_3 formed between electrodes E2_3 and E2_4.

References C1_1 to C2_3 are also used to designate the capacitance values of these capacitors. It should be noted that for a structure such as the one of figures 1A and 1B split in two, C1_1 and C2_1 are equal to C1/2 (with C1 being the capacitance of capacitor C1 of figures 1A and 1B), C1_2 and C2_2 are equal to C2/2 (with C2 being the capacitance of capacitor C2 of figures 1A and 1B), and C1_3 and C2_3 are equal to C3/2 (with C3 being the capacitance of capacitor C3 of figures 1A and 1B). This corresponds to a situation where the X-th capacitor of the N-1 stacked capacitors of the first stacked capacitive structure has the same capacitance value as the X-the capacitor of the N-1 stacked capacitors of the second stacked capacitive structure.

Here, C1_1 and C2_3 are connected in parallel, and are equivalent to a capacitor of capacitance Ca= C1/2 + C3/2.

C1_2 and C2_2 are connected in parallel, and are equivalent to a capacitor of capacitance Cb= C2/2 + C2/2.

C1_3 and C2_1 are connected in parallel, and are equivalent to a capacitor of capacitance Cc= C1/2 + C3/2.

With the decreasing capacitance value when going towards the top in each capacitive stacked structure, it appears that Ca, Cb, and Cc are approximately all equal to one another.

Also, from figure 3, it appears that the three equivalent capacitors Ca, Cb, and Cc are connected in series, in a manner such that a capacitor is formed between electrodes E1_4 and E2_4, having a total capacitance Ctot of:

$$\frac{1}{Ctot} = \frac{1}{Ca} + \frac{1}{Cb} + \frac{1}{Cc}$$

$$Ctot = \frac{Ca \times Cb \times Cc}{(Cb \times Cc + Ca \times Cc + Ca \times Cb)}$$

For example, if Ca, Cb, and Cc are all approximately equal to 13.5nF, Ctot is equal to 4.5nF.

On figure 3, a further simplified equivalent circuit EQC has been represented (the equivalency is embodied by the double sides arrow), wherein a single equivalent capacitor is represented to illustrate the capacitance *Ctot* between electrodes E1_1 and E2_4, and the two bulk diodes BD1 and BD2 are also represented. These two diodes form a voltage limiting device that protects the capacitor.

Figure 4 is a side view of the device described in reference to figures 2 and 3.

Contrary to figures 1A and 1B, here, the two stacked capacitive structures are formed not on a cavity, but on pillars surrounded by trenches. More precisely, the first stacked capacitive structure SCS1 is formed above a pillar PI1 formed in a substrate SUB, and the second stacked capacitive structure SCS2 is formed above a pillar PI2 is formed above a pillar PI2 formed in the substrate SUB. The pillars can be the ones of document WO 2007125510. While a single pillar is shown for each structure, additional pillars can be formed.

This figure shows that the two doped regions forming electrodes E1_1 and E2_1 are distinct and separated.

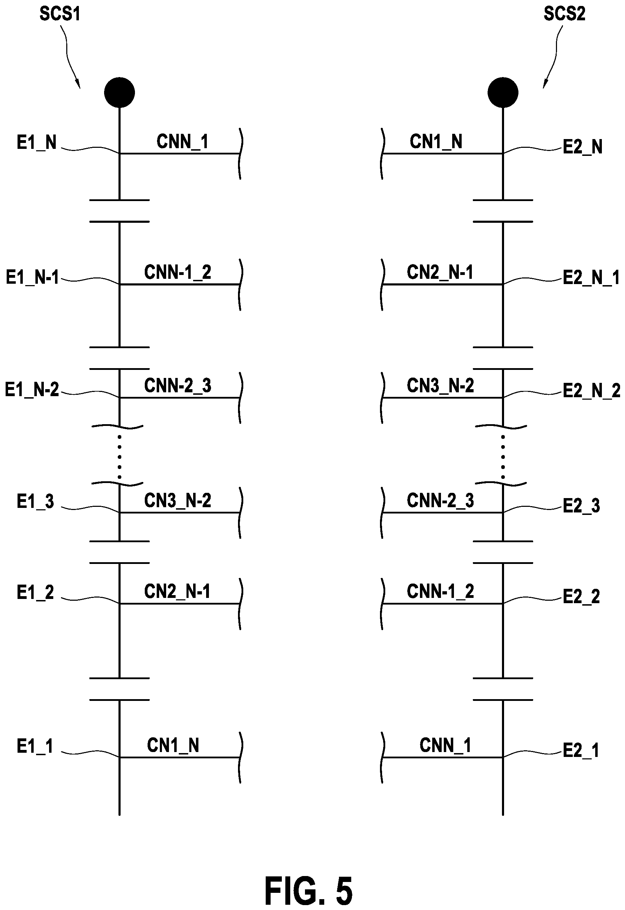

Figure 5 is an exemplary equivalent circuit for a device according to an example, not limited to structures having 4 electrodes, but comprising any number N superior or equal to 3 of electrodes.

The first stacked capacitive structure SCS1 comprises N electrodes E1_1 to E1_N, and the second stacked capacitive structure comprises N electrodes E2_1 to E2_N.

The device comprises N electrical connections for connecting each electrode of the first stacked capacitive structure SCS1 to a respective electrode of the second stacked capacitive structure SCS2, wherein the X-th (X comprised between 1 and N) electrode of the first stacked capacitive structure is connected by an electrical connection of the N electrical connections to the N-X+1-th electrode of the second stacked capacitive structure.

In other words, the electrical connection between the X-th electrode of the first stacked capacitive structure and the N-X+1-th electrode of the second stacked capacitive structure are connected by electrical connection CNX_N-X+1, as illustrated on the figure.

Calculating the overall capacitance can be performed similarly to the computation of Ctot described above in reference to figure 3.

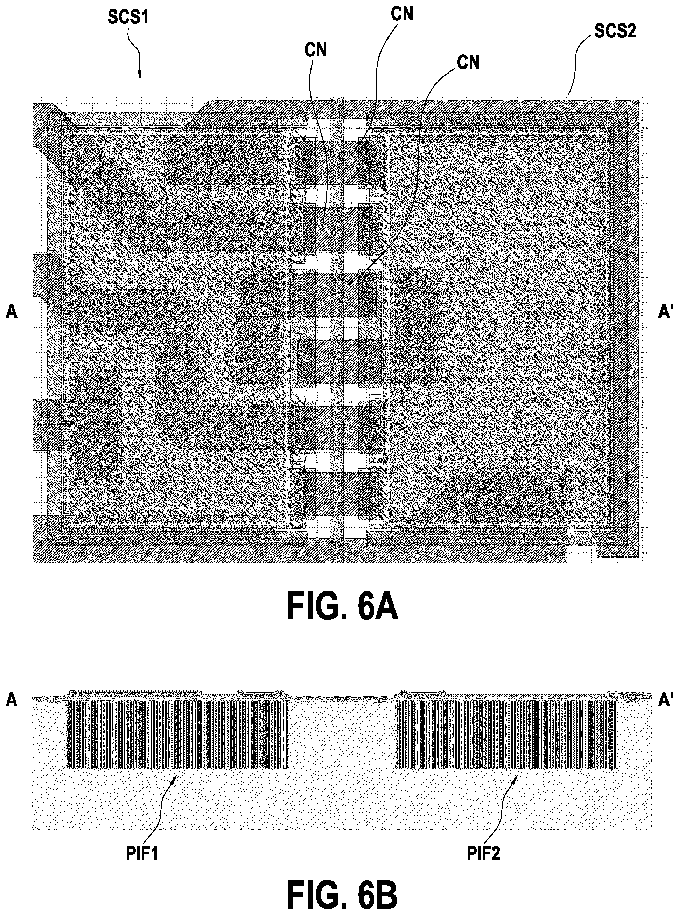

Figure 6A is an exemplary structure in which the first stacked capacitive structure SCS1 has a rectangular shape, when observed from the top as shown on the figure, and the second stacked capacitive structure SCS2 has the same rectangular shape.

Various connections CN are shown on the figure, to connect together electrodes from the two stacks.

Figure 6B is a cross section of the device shown on figure 6A, along plane A-A' shown on figure 6A. This figure shows that the first stacked capacitive structure SCS1 is formed above a pillar field PIF1 and the second stacked capacitive structure SCS2 is formed above a pillar field PIF2. This arrangement, using pillars, provides a large surface area to be used to obtain a large capacitance value.

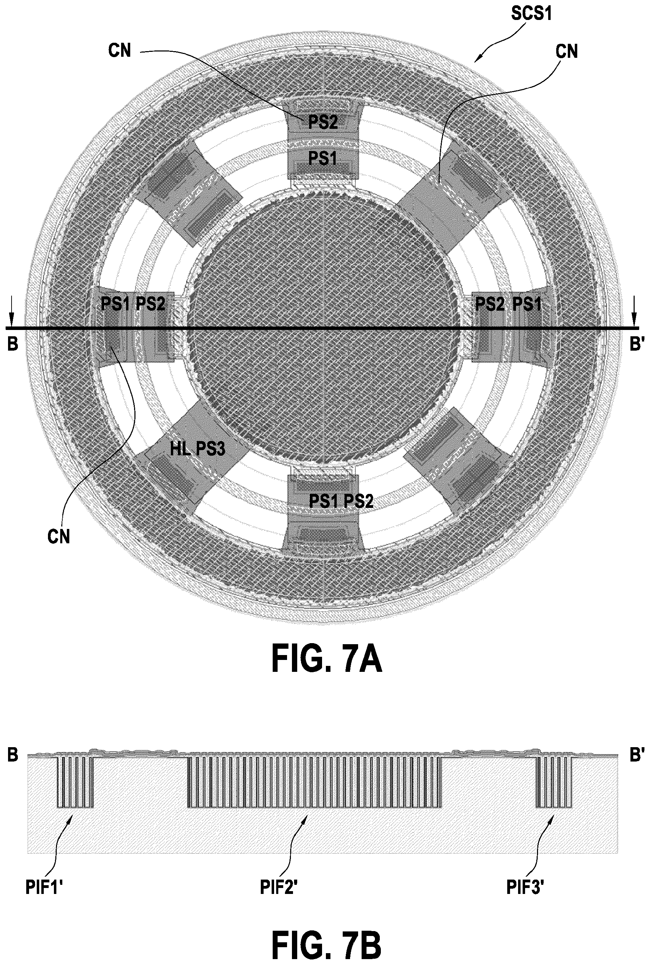

Figure 7A is an exemplary structure in which the first stacked capacitive structure SCS1 has an annular shape and surrounds the second stacked capacitive structure (which has a circular shape here), when observed from the top as shown on the figure, and the second stacked capacitive structure SCS2 has the same rectangular shape.

Various connections CN are shown on the figure, to connect together electrodes from the two stacks.

In this arrangement, the surface area occupied by both stacks is identical (measured in the plane seen in the figure).

Figure 7B is a cross section of the device shown on figure 7A, along plane B-B' shown on figure 7A. Again, the first stacked capacitive structure SCS1 is formed above a pillar field PIF1' and the second stacked capacitive structure SCS2 is formed above a pillar field PIF2'.

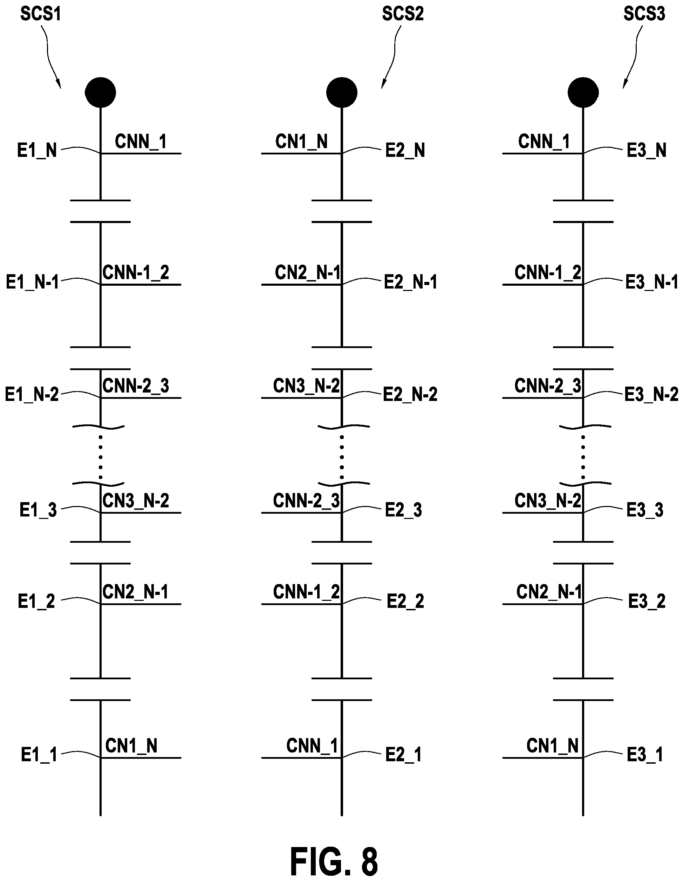

Figure 8 is an equivalent circuit showing a supplementary stacked capacitive structure SCS3.

It should be noted that the electrical devices can comprise more than two stacked capacitive structure to balance even more the differences in terms of capacitance obtained between bottom capacitors and top capacitors.

The supplementary stacked capacitive structure SCS3 comprises N electrodes E3_1, ..., E3_N, from the first to the N-th electrode, each having a 3D shape, and conformally stacked from the first electrode of the N electrodes at the bottom of the structure to the N-th electrode at the top of the structure, the electrodes being all separated by N-1 dielectric layers so that N-1 stacked capacitors are formed in the second stacked capacitive structure. The supplementary stacked capacitive structure is identical to the stacked capacitive structures SCS1 and SCS 2 described hereinabove in reference to figure 5.

The N electrical connections CN1_N, ..., CNN_1 are used so that the X-th electrode of the supplementary stacked capacitive structure is connected to the N-X+1-th electrode of either the second stacked capacitive structure.

It should be noted that in this configuration, it balances the second stacked capacitive structure.

Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

**Claims**

1. An electrical device comprising at least a first stacked capacitive structure (SCS1) and a second stacked capacitive structure (SCS2), the first and the second stacked capacitive structure being adjacent and formed above a same substrate,

   wherein the first stacked capacitive structure comprises N electrodes (E1_1, ..., E1_N), from the first to the N-th electrode, each having a 3D shape, and conformally stacked from the first electrode of the N electrodes at the bottom of the structure to the N-th electrode at the top of the structure, the electrodes being all separated by N-1 dielectric layers so that N-1 stacked capacitors (C1_1, ..., C1_3) are formed in the first stacked capacitive structure,
wherein the second stacked capacitive structure comprises N electrodes (E2_1, ..., E2_N), from the first to the N-th electrode, each having a 3D shape, and conformally stacked from the first electrode of the N electrodes at the bottom of the structure to the N-th electrode at the top of the structure, the electrodes being all separated by N-1 dielectric layers so that N-1 stacked capacitors (C2_1, ..., C2_3) are formed in the second stacked capacitive structure,
further comprising N electrical connections (CN1_N, ..., CNN_1) for connecting each electrode of the first stacked capacitive structure to a respective electrode of the second stacked capacitive structure, wherein the X-th electrode of the first stacked capacitive structure is connected by an electrical connection of the N electrical connections to the N-X+1-th electrode of the second stacked capacitive structure.

2. The electrical device of claim 1, wherein the X-th capacitor of the N-1 stacked capacitors of the first stacked capacitive structure has the same capacitance value as the X-the capacitor of the N-1 stacked capacitors of the second stacked capacitive structure.

3. The electrical device of claim 1 or 2, wherein the first stacked capacitive structure has an annular shape and surrounds the second stacked capacitive structure, or
the first stacked capacitive structure has a rectangular shape and the second stacked capacitive structure has the same rectangular shape.

4. The electrical device of any one of claims 1 to 3, wherein the first electrode of the first stacked capacitive structure comprises a semiconductor region having a 3D shape and the first electrode of the second stacked capacitive structure comprises a semiconductor region having a 3D shape.

5. The electrical device of claim 4, wherein the semiconductor regions having a 3D shape of the first electrodes comprise a plurality of holes, or a plurality of trenches, or a plurality of pillars.

6. The electrical device of claim 4 or 5, wherein the semiconductor region of the first electrode of the first stacked capacitive structure is formed by doping a portion of a semiconductor substrate, and the device comprises a first diode (BD1) formed between the semiconductor region of the first electrode of the first stacked capacitive structure and the undoped semiconductor substrate, and

   the semiconductor region of the first electrode of the second stacked capacitive structure is formed by doping a portion of the same semiconductor substrate, and the device comprises a second diode (BD2) formed between the semiconductor region of the first electrode of the second stacked capacitive structure and the undoped semiconductor substrate,
   wherein the anodes of the first diode and of the second diode are connected together through the undoped semiconductor substrate.

7. The electrical device of any one of claims 1 to 6, further comprising a supplementary stacked capacitive structure (SCS3) comprising N electrodes (E3_1, ..., E3_N), from the first to the N-th electrode, each having a 3D shape, and conformally stacked from the first electrode of the N electrodes at the bottom of the structure to the N-th electrode at the top of the structure, the electrodes being all separated by N-1 dielectric layers so that N-1 stacked capacitors are formed in the second stacked capacitive structure, and wherein the N electrical connections (CN1_N, ..., CNN_1) also connect the X-th electrode of the supplementary stacked capacitive structure to the N-X+1-th electrode of either the first or the second stacked capacitive structure.

8. The electrical device of any one of claims 1 to 7, wherein N is equal to 4.

9. A method of manufacturing an electrical device comprising at least a first stacked capacitive structure (SCS1) and a second stacked capacitive structure (SCS2), the first and the second stacked capacitive structure being adjacent and formed above a same substrate,

   wherein forming the first stacked capacitive structure comprises forming successively N electrodes (E1_1, ..., E1_N), from the first to the N-th electrode, each having a 3D shape, and conformally stacked from the first electrode of the N electrodes at the bottom of the structure to the N-th electrode at the top of the structure, and forming N-1 dielectric layers separating all the electrodes so that N-1 stacked capacitors (C1_1, ..., C1_3) are formed in the first stacked capacitive structure,
   wherein forming the second stacked capacitive structure comprises forming successively N electrodes (E2_1, ..., E2_N), from the first to the N-th electrode, each having a 3D shape, and conformally stacked from the first electrode of the N electrodes at the bottom of the structure to the N-th electrode at the top of the structure, and forming N-1 dielectric layers separating all the electrodes so that N-1 stacked capacitors (C2_1, ..., C2_3) are formed in the second stacked capacitive structure,
further comprising forming N electrical connections (CN1_N, ..., CNN_1) for connecting each electrode of the first stacked capacitive structure to a respective electrode of the second stacked capacitive structure, wherein the X-th electrode of the first stacked capacitive structure is connected by an electrical connection of the N electrical connections to the N-X+1-th electrode of the second stacked capacitive structure.

10. The method of claim 9, wherein the X-th capacitor of the N-1 stacked capacitors of the first stacked capacitive structure has the same capacitance value as the X-the capacitor of the N-1 stacked capacitors of the second stacked capacitive structure.

11. The method of claim 9 or 10, wherein the first stacked capacitive structure has an annular shape and surrounds the second stacked capacitive structure, or the first stacked capacitive structure has a rectangular shape and the second stacked capacitive structure has the same rectangular shape.

12. The method of any one of claims 9 to 11, wherein the first electrode of the first stacked capacitive structure comprises a semiconductor region having a 3D shape and the first electrode of the second stacked capacitive structure comprises a semiconductor region having a 3D shape.

13. The method of claim 12, wherein the semiconductor regions having a 3D shape of the first electrodes comprise a plurality of holes, or a plurality of trenches, or a plurality of pillars.

14. The method of claim 12 or 13, wherein the semiconductor region of the first electrode of the first stacked capacitive structure is formed by doping a portion of a semiconductor substrate, so that a first diode (BD1) is formed between the semiconductor region of the first electrode of the first stacked capacitive structure and the undoped semiconductor substrate, and

the semiconductor region of the first electrode of the second stacked capacitive structure is formed by doping a portion of the same semiconductor substrate, so that a second diode (BD2) is formed between the semiconductor region of the first electrode of the second stacked capacitive structure and the undoped semiconductor substrate,
wherein the anodes of the first diode and of the second diode are connected together through the undoped semiconductor substrate.

15. The method of any one of claims 9 to 14, further comprising forming a supplementary stacked capacitive structure (SCS3) comprising N electrodes (E3_1, ..., E3_N), from the first to the N-th electrode, each having a 3D shape, and conformally stacked from the first electrode of the N electrodes at the bottom of the structure to the N-th electrode at the top of the structure, the electrodes being all separated by N-1 dielectric layers so that N-1 stacked capacitors are formed in the second stacked capacitive structure, and wherein the N electrical connections (CN1_N, ..., CNN_1) also connect the X-th electrode of the supplementary stacked capacitive structure to the N-X+1-th electrode of either the first or the second stacked capacitive structure.

16. The method of any one of claims 9 to 15, wherein N is equal to 4.

**FIG. 1A**

**FIG. 1B**

**FIG. 2**

**FIG. 3**

**FIG. 4**

SCS1

CN4_1
CN3_2
CN2_3
CN1_4
E2_3
E2_2
E1_4
E1_3
E1_2

SCS2

CN1_4
CN2_3
CN3_2
CN4_1
E2_4

E1_1
E2_1

SUB

PI1
PI2

EP 4 184 537 A1

12

SCS1

E1_N       CNN_1

E1_N-1     CNN-1_2

E1_N-2     CNN-2_3

E1_3      CN3_N-2

E1_2      CN2_N-1

E1_1      CN1_N

SCS2

CN1_N      E2_N

CN2_N-1     E2_N_1

CN3_N-2     E2_N_2

CNN-2_3     E2_3

CNN-1_2     E2_2

CNN_1      E2_1

# FIG. 5

EP 4 184 537 A1

**FIG. 6A**

**FIG. 6B**

**FIG. 7A**

**FIG. 7B**

**FIG. 8**

Europäisches
Patentamt

European
Patent Office

Office européen
des brevets

# EUROPEAN SEARCH REPORT

Application Number

EP 21 30 6605

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 471 500 B1 (CHEN SHUXIAN [US] ET AL) 30 December 2008 (2008-12-30) | 1-3,7, 9-11,15 | INV. H01G4/012 |
| A | * columns 3-6; figures 1-6 * | 4-6,8, 12-14,16 | H01G4/30 H01G4/33 H01G4/38 |
| A | DE 10 2012 003118 A1 (MAXIM INTEGRATED PRODUCTS [US]) 23 August 2012 (2012-08-23) * abstract; figures 2-3 * | 1-16 | H01L49/02 |
| A | US 2006/091443 A1 (UEDA KAZUHIKO [JP] ET AL) 4 May 2006 (2006-05-04) * paragraphs [0037] - [0053]; figures 1-10 * | 1-16 | |
| A | EP 3 754 725 A1 (SHENZHEN GOODIX TECH CO LTD [CN]) 23 December 2020 (2020-12-23) * abstract; figures 1-17 * | 1-16 | |

**TECHNICAL FIELDS SEARCHED (IPC)**

H01G
H01L

The present search report has been drawn up for all claims

| Place of search | Date of completion of the search | Examiner |
|---|---|---|
| Munich | 29 April 2022 | Rucha, Johannes |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 30 6605

This annex lists the patent family members relating to the patent documents cited in the above-mentioned European search report.
The members are as contained in the European Patent Office EDP file on
The European Patent Office is in no way liable for these particulars which are merely given for the purpose of information.

29-04-2022

| Patent document cited in search report | | Publication date | Patent family member(s) | | Publication date |
|---|---|---|---|---|---|
| US 7471500 | B1 | 30-12-2008 | US 7471500 | B1 | 30-12-2008 |
| | | | US 7639474 | B1 | 29-12-2009 |
| DE 102012003118 | A1 | 23-08-2012 | CN 102709311 | A | 03-10-2012 |
| | | | DE 102012003118 | A1 | 23-08-2012 |
| | | | US 8963287 | B1 | 24-02-2015 |
| | | | US 2012211865 | A1 | 23-08-2012 |
| US 2006091443 | A1 | 04-05-2006 | JP 2006128523 | A | 18-05-2006 |
| | | | US 2006091443 | A1 | 04-05-2006 |
| EP 3754725 | A1 | 23-12-2020 | CN 111615751 | A | 01-09-2020 |
| | | | EP 3754725 | A1 | 23-12-2020 |
| | | | US 2021005705 | A1 | 07-01-2021 |
| | | | WO 2020132884 | A1 | 02-07-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007125510 A